# EUROPEAN PATENT APPLICATION

(11) **EP 4 819 476 A1**
(43) Date of publication of application: **07.10.2026**
(21) Application number: 24896954.5
(22) Date of filing: 20.06.2024
(51) Int. Cl.: H02M 7/48

(54) **POWER CONVERSION DEVICE AND MOTOR MODULE**

(30) Priority: 29.11.2023 JP 2023201656
(71) Applicant: Nidec Corporation, Minami-ku, Kyoto-shi, Kyoto 601-8205 (JP)
(72) Inventor: SUGAWARA Yuri, Kyoto-shi, Kyoto 601-8205 (JP)
(74) Representative: Viering, Jentschura & Partner mbB Patent- und Rechtsanwälte
(86) International application number: PCT/JP2024/022330
(87) International publication number: WO 2025/115262

(57) **Abstract**

The present invention comprises: a capacitor module having a capacitor element and a case part for accommodating the capacitor element; a power module having a power semiconductor element for performing power conversion; a control board for driving the power module; and a bus bar module having a bus bar. The capacitor element has a capacitor body part and a first connection terminal extending from the capacitor body part to one side in a first direction. The power module has a second connection terminal. The bus bar electrically connects the first connection terminal and the second connection terminal. The case part has: a first housing part which is recessed from one side in the first direction to the other side in the first direction and accommodates the capacitor body part; and a first flow path through which a refrigerant flows.

## Description

### Field of the Invention

The present invention relates to a power conversion device and a motor module.

### Background

As a power conversion device for supplying power to a motor, for example, there is disclosed a power conversion device including a power module unit including a power semiconductor, a capacitor unit including a capacitor element, and a refrigerant flow channel through which a refrigerant for cooling the capacitor element flows, the power module unit and the capacitor element being electrically connected by busbars (for example, Japanese Unexamined Patent Application Publication: JP 2013-031330 A).

### Citation List

### Patent Literature

Patent Document 1: Japanese Unexamined Patent Application Publication: JP 2013-031330 A

### Summary

### Technical Problem

**In** the power conversion device described in Patent Document 1, since the busbars are arranged between the capacitor element and the refrigerant flow channel, the thermal resistance between the capacitor element and the refrigerant flow channel tends to increase. Therefore, increasing an amount of heat transferred from the capacitor element to the refrigerant flowing through the refrigerant flow channel is difficult, and there has been a risk that the temperature of the capacitor element becomes excessively high. As a result, there has been a risk that deterioration of the capacitor element is accelerated.

One aspect of the present invention, in view of the above circumstances, is to provide a power conversion device and a motor module capable of suppressing an excessive increase in a temperature of a capacitor element.

### Solution to Problem

One aspect of a power conversion device of the present invention includes a capacitor module including a capacitor element and a case portion accommodating the capacitor element, a power module including a power semiconductor element configured to perform power conversion, a control board configured to drive the power semiconductor element, and a busbar module including a busbar. The capacitor element includes a capacitor main body portion and a first connection terminal extending from the capacitor main body portion toward one side of a first direction. The power module includes a second connection terminal. The busbar electrically connects the first connection terminal and the second connection terminal. The case portion includes a first accommodating portion recessed from the one side of the first direction toward the other side of the first direction and accommodating the capacitor main body portion, and a first flow channel through which a refrigerant flows.

One aspect of a motor module of the present invention includes the power conversion device described above and a motor driven by a current supplied from the power conversion device.

### Advantageous Effects of Invention

According to one aspect of the present invention, in a power conversion device and a motor module, an excessive increase in a temperature of a capacitor element can be suppressed.

### Brief Description of the Drawings

FIG. 1 is a perspective view illustrating a motor module according to a first embodiment.
FIG. 2 is a perspective view illustrating a part of the motor module according to the first embodiment.
FIG. 3 is a cross-sectional view illustrating a part of a power conversion device according to the first embodiment.
FIG. 4 is a cross-sectional view illustrating a part of the power conversion device according to the first embodiment, and is a cross-sectional view taken along line IV-IV in FIG. 3.
FIG. 5 is a cross-sectional view illustrating a part of a power conversion device according to a second embodiment.

### Detailed Description

Hereinafter, a power conversion device according to an embodiment of the present invention will be described with reference to the accompanying drawings. The scope of the present invention is not limited to the following embodiments, and can be optionally changed within the scope of the technical idea of the present invention. In addition, in the following drawings, scales, numbers, and the like may differ from those of the actual structure in order to facilitate understanding of each configuration.

### First Embodiment

In the following description, a first direction D1 is appropriately indicated in each drawing. In the present embodiment, the first direction D1 is the up-down direction of a power conversion device 10. In the following description, a side toward which an arrow of the first direction D1 points (+D1 side) is referred to as "one side of the first direction D1" or an "upper side". The side opposite to the side toward which an arrow of the first direction D1 points (-D1 side) is referred to as "the other side of the first direction D1" or a "lower side".

In the following description, a second direction D2 is appropriately indicated in each drawing. In the present embodiment, the second direction D2 is the left-right direction of the power conversion device 10. The second direction D2 intersects with the first direction D1. In the present embodiment, the second direction D2 is orthogonal to the first direction D1. In the following description, the side toward which an arrow of the second direction D2 points (+D2 side) is referred to as a "left side". The side opposite to the side toward which an arrow of the second direction D2 points (-D2 side) is referred to as a "right side".

**In** the following description, a third direction D3 is appropriately indicated in each drawing. The third direction D3 is a direction orthogonal to both the first direction D1 and the second direction D2. The third direction D3 is the front-rear direction of the power conversion device 10. **In** the following description, the side toward which an arrow of the third direction D3 points (+D3 side) is referred to as a "front side". The side opposite to the side toward which the arrow of the third direction D3 points (-D3 side) is referred to as a "rear side".

Note that the upper side, the lower side, the left side, the right side, the front side, and the rear side are merely names for describing the relative positional relationships of respective portions, and the actual arrangement relationships and the like may be the arrangement relationships and the like other than the arrangement relationships and the like indicated by these names.

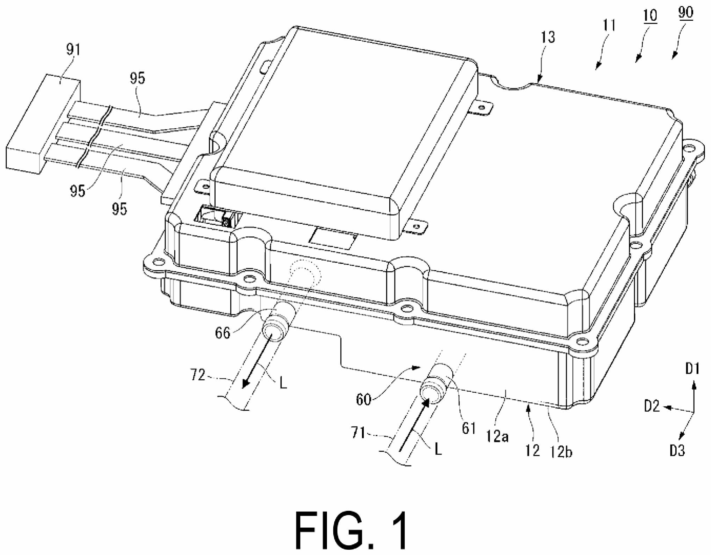

FIG. 1 is a perspective view illustrating a motor module 90 according to the present embodiment. The motor module 90 includes the power conversion device 10 and a motor 91. The motor 91 is, for example, a drive device that is mounted on a vehicle and rotates an axle of the vehicle. The motor 91 is driven by a current supplied from the power conversion device 10. The vehicle on which the motor module 90 is mounted is a vehicle that uses the motor 91 as a power source, such as a hybrid electric vehicle (HEV), a plug-in hybrid vehicle (PHV), and an electric vehicle (EV).

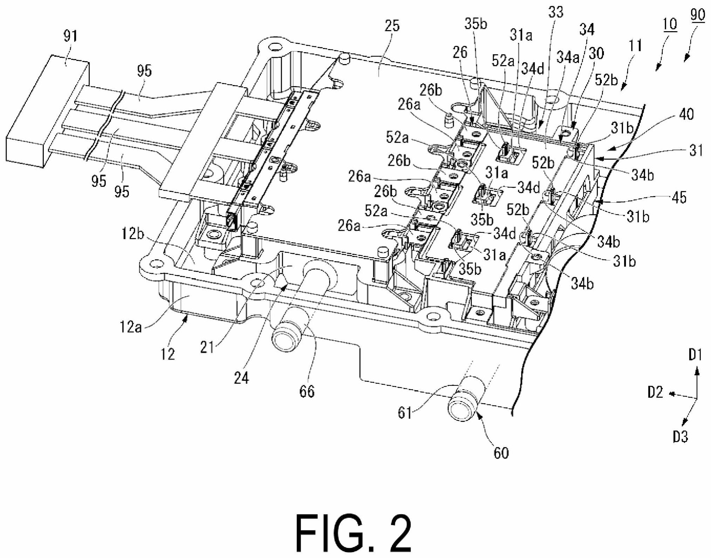

The power conversion device 10 supplies a current to the motor 91. The power conversion device 10 generates a current to be supplied to the motor 91, and supplies currents to a U-phase coil, a V-phase coil, and a W-phase coil included in the motor 91, respectively. As illustrated in FIG. 2, the power conversion device 10 includes a housing 11, a holding portion 21, a power module 24, a control board 25, a busbar module 30, a capacitor module 40, and a refrigerant flow channel 60.

The housing 11 internally accommodates respective members constituting the power conversion device 10, such as the holding portion 21, the power module 24, the control board 25, the busbar module 30, and the capacitor module 40. As illustrated in FIG. 1, the housing 11 has a box shape having a substantially rectangular parallelepiped shape. When viewed from the first direction D1, the housing 11 has a substantially rectangular shape having long sides extending in the second direction D2. The housing 11 includes a first housing 12 and a second housing 13.

As illustrated in FIG. 2, the first housing 12 has a box shape opening toward the upper side (-D3 side). The first housing 12 includes a peripheral wall portion 12a and a bottom wall portion 12b. As illustrated in FIG. 1, the peripheral wall portion 12a has a quadrangular tubular shape protruding in the first direction D1. The peripheral wall portion 12a surrounds the holding portion 21, the power module 24, the control board 25, the busbar module 30, and the capacitor module 40 in the second direction D2 and the third direction D3. Of the wall portions of the peripheral wall portion 12a, a wall portion that is positioned on the front side (+D3 side) and extending in the second direction D2 is provided with a first conduit 61 and a fourth conduit 66 extending in a third direction D3.

The first conduit 61 is arranged on the right side (-D2 side) relative to the fourth conduit 66. The front-side (+D3 side) portions of each of the first conduit 61 and the fourth conduit 66 protrude toward the front side from the peripheral wall portion 12a. A supply pipe portion 71 is connected to the front-side end portion of the first conduit 61. A discharge pipe portion 72 is connected to the front-side end portion of the fourth conduit 66. As illustrated in FIG. 2, rear-side (-D3 side) portions of each of the first conduit 61 and the fourth conduit 66 protrude toward the rear side of the peripheral wall portion 12a. Although not illustrated, the rear-side end portion of the first conduit 61 is connected to the capacitor module 40. The rear-side end portion of the fourth conduit 66 is connected to the holding portion 21. A refrigerant L flows inside the first conduit 61 and the fourth conduit 66.

The bottom wall portion 12b has a plate shape extending in a direction orthogonal to the first direction D1. The plate surface of the bottom wall portion 12b faces the first direction D1. The outer edge portion of the bottom wall portion 12b is connected to the lower end of the peripheral wall portion 12a.

The second housing 13 illustrated in FIG. 1 has a box shape opening toward the lower side (-D1 side). The second housing 13 is fixed to the upper end of the first housing 12.

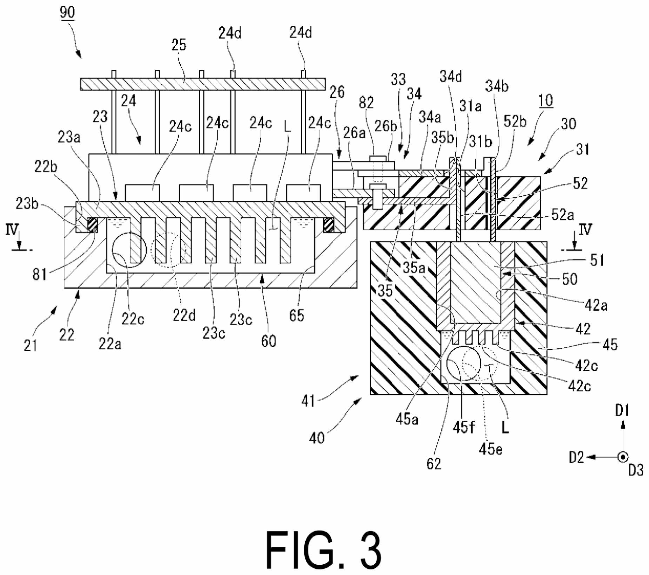

As illustrated in FIG. 3, the holding portion 21 holds the power module 24. The holding portion 21 is arranged on the lower side (-D1 side) relative to the power module 24. The power module 24 is fixed to the upper end of the holding portion 21. The holding portion 21 includes a holding case 22 and a heat sink 23.

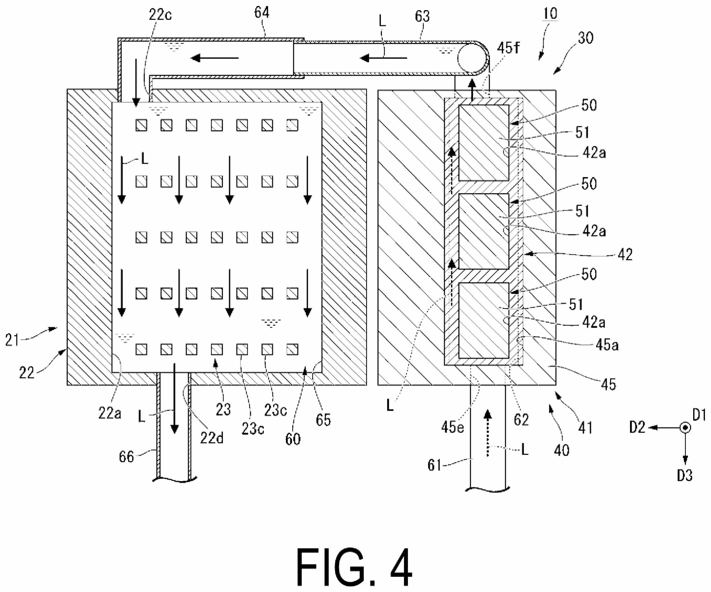

As illustrated in FIG. 4, the holding case 22 has a substantially rectangular parallelepiped shape extending in the third direction D3. As illustrated in FIG. 3, two surfaces of the holding case 22 face the first direction D1, and the other two surfaces of the holding case 22 face the second direction D2. The holding case 22 is provided with a first recess portion 22a, a second recess portion 22b, a third hole portion 22c, and a fourth hole portion 22d.

The first recess portion 22a is recessed toward the lower side from the surface of the holding case 22 facing the upper side (+D1 side). As illustrated in FIG. 4, when viewed from the first direction D1, the first recess portion 22a has a substantially rectangular shape. As illustrated in FIG. 3, the second recess portion 22b is recessed toward the lower side from the surface of the holding case 22 facing the upper side. Although not illustrated, when viewed from the first direction D1, the second recess portion 22b has a substantially rectangular annular shape having long sides extending in the third direction D3. The second recess portion 22b surrounds the first recess portion 22a from outer sides in each of the second direction D2 and the third direction D3.

As illustrated in FIG. 4, of wall portions of the holding case 22, the third hole portion 22c is a hole arranged on the rear side (-D3 side) and penetrating a wall portion extending in the second direction D2 in the third direction D3. The outside of the holding case 22 is connected to the inside of the first recess portion 22a through the third hole portion 22c. A third conduit 64 is connected to the third hole portion 22c. Of wall portions of the holding case 22, the fourth hole portion 22d is a hole arranged on the front side (+D3 side) and penetrating a wall portion extending in the second direction D2 in the third direction D3. The outside of the holding case 22 is connected to the inside of the first recess portion 22a through the fourth hole portion 22d. The fourth conduit 66 is connected to the fourth hole portion 22d.

The heat sink 23 illustrated in FIG. 3 transfers heat that is generated in the power module 24 to the refrigerant L flowing inside the first recess portion 22a of the holding case 22. In the present embodiment, the heat sink 23 is constituted by, for example, metal materials such as copper and aluminum. The heat sink 23 includes a main body portion 23a, a fixing portion 23b, and a plurality of fin portions 23c.

The main body portion 23a has a plate shape extending in a direction orthogonal to the first direction D1. The plate surface of the main body portion 23a faces the first direction D1. The main body portion 23a closes the first recess portion 22a from the upper side (+D1 side). The power module 24 is fixed to the surface of the main body portion 23a facing the upper side. Thus, the holding portion 21 holds the power module 24.

The fixing portion 23b protrudes toward the lower side from the outer edge of the main body portion 23a. Although not illustrated, when viewed from the first direction D1, the fixing portion 23b has a substantially rectangular annular shape having long sides extending in the third direction D3. The fixing portion 23b is arranged inside the second recess portion 22b. The fixing portion 23b is fixed to the inner surface of the second recess portion 22b. Thus, the heat sink 23 is fixed to the holding case 22. A sealing member 81 is arranged between the inner peripheral surface of the fixing portion 23b and the inner surface of the second recess portion 22b. The sealing member 81 contacts both the inner peripheral surface of the fixing portion 23b and the inner surface of the second recess portion 22b. Thus, the sealing member 81 seals a space between the heat sink 23 and the holding case 22.

Each of the plurality of fin portions 23c protrudes toward the lower side from the main body portion 23a. Each fin portion 23c is arranged inside the first recess portion 22a. As illustrated in FIG. 4, in the present embodiment, each fin portion 23c is arranged at intervals along each of the second direction D2 and the third direction D3. Each fin portion 23c may be arranged at intervals along only one of the second direction D2 and the third direction D3. As illustrated in FIG. 3, in the present embodiment, each fin portion 23c is arranged at intervals in the first direction D1 from the surface of the first recess portion 22a facing the upper side (+D1 side). Each fin portion 23c may contact the surface of the first recess portion 22a facing the upper side. Note that the heat sink 23 may not include the fin portion 23c.

The holding portion 21 is provided with a second flow channel 65 through which the refrigerant L flows. The second flow channel 65 is constituted by the inner surface of the first recess portion 22a, the surface of the main body portion 23a facing the lower side, and the outer surface of each fin portion 23c. Each fin portion 23c protrudes inside the second flow channel 65. Each fin portion 23c contacts the refrigerant L flowing through the second flow channel 65.

The power module 24 generates a current having a predetermined waveform from a current supplied by an external power source (not illustrated), and supplies the current to the motor 91. More specifically, the power conversion device 10 generates phase currents (a U-phase current, a V-phase current, and a W-phase current) to be supplied to each of a U-phase coil, a V-phase coil, and a W-phase coil (not illustrated) included in the motor 91. In the present embodiment, the power conversion device 10 is an inverter that converts a direct current into an alternating current. The power module 24 includes a power semiconductor element 24c and a second connection terminal 26.

The power semiconductor element 24c generates a current having a predetermined waveform from a current supplied by an external power source (not illustrated). Thus, the power semiconductor element 24c performs power conversion. In the present embodiment, the power semiconductor element 24c converts, as an example, a direct current into an alternating current. In the present embodiment, the power semiconductor element 24c is an electronic element such as a metal oxide semiconductor field effect transistor (MOSFET) and an insulated gate bipolar transistor (IGBT). The power module 24 includes a plurality of power semiconductor elements 24c. Although not illustrated, in the present embodiment, the power module 24 includes six power semiconductor elements 24c. Each of the pair of power semiconductor elements 24c generates one phase current of one of the U-phase current, the V-phase current, and the W-phase current.

The second connection terminal 26 electrically connects the power semiconductor elements 24c arranged inside the power module 24 and the busbar module 30. The second connection terminal 26 has a plate shape protruding from the power module 24 toward the right side (-D2 side). The plate surface of the second connection terminal 26 faces the first direction D1. The second connection terminal 26 is made of metal. In the present embodiment, the power module 24 includes six second connection terminals 26. The six second connection terminals 26 include three second positive terminals 26a and three second negative terminals 26b.

Each second positive terminal 26a is arranged at intervals in the third direction D3. Each second positive terminal 26a is electrically connected to a different pair of power semiconductor elements 24c. The second negative terminals 26b are arranged at intervals in the third direction D3. When viewed from the first direction D1, each second negative terminal 26b is arranged at a position offset from the second positive terminal 26a in the third direction D3. As illustrated in FIG. 3, each second negative terminal 26b is arranged on the upper side (+D1 side) relative to each second positive terminal 26a. Each second negative terminal 26b is electrically connected to a different pair of power semiconductor elements 24c.

Output terminals 95 illustrated in FIG. 2 are paths through which a current generated by the power semiconductor elements 24c flows. The output terminals 95 have a plate shape protruding from the power module 24 toward the left side (+D2 side). The output terminals 95 are made of metal. Although not illustrated, right-side (+D2 side) end portions of the output terminals 95 are electrically connected to the power semiconductor elements 24c included in the power module 24. In addition, left-side end portions of the output terminals 95 are connected to terminals connected to coils of the motor 91. Accordingly, the phase current is supplied from the power module 24 to the coils of the motor 91. In the present embodiment, the power module 24 has three output terminals 95. Each output terminal 95 is arranged side by side in the third direction D3. A current of one of the U-phase current, the V-phase current, and the W-phase current flows through each output terminal 95.

The control board 25 is a printed circuit board extending in a direction orthogonal to the first direction D1. When viewed from the first direction D1, the control board 25 has a substantially rectangular shape having long sides extending in the third direction D3. The control board 25 drives the power semiconductor elements 24c. Although not illustrated, a plurality of electronic elements, such as an integrated circuit (IC) and a resistor, are mounted on the control board 25. As illustrated in FIG. 3, the control board 25 is arranged on the upper side (+D1 side) relative to the heat sink 23. The control board 25 is supported in the first direction D1 by a plurality of connection pins 24d. Each connection pin 24d has conductive properties. Each connection pin 24d electrically connects the power module 24 and the control board 25. Accordingly, each power semiconductor element 24c and the control board 25 are electrically connected. The control board 25 controls power conversion of the power module 24 by providing control pulses to each power semiconductor element 24c.

In the present embodiment, the busbar module 30 is arranged on the right side (-D2 side) relative to the power module 24 and on the upper side (+D1 side) relative to the capacitor module 40. The busbar module 30 includes a first holding member 31 and a plurality of busbars 33.

Although not illustrated, the first holding member 31 has a substantially rectangular parallelepiped shape extending in the third direction D3. Two surfaces of the first holding member 31 face the first direction D1, and the other two surfaces of the first holding member 31 face the second direction D2. In the present embodiment, the first holding member 31 is made of resin and has insulating properties. In the present embodiment, the first holding member 31 is molded by insert molding using the plurality of busbars 33 as insert members. Accordingly, the first holding member 31 holds each busbar 33. The first holding member 31 is provided with a first through-hole 31a and a second through-hole 31b.

Each of the first through-hole 31a and the second through-hole 31b is a hole penetrating the first holding member 31 in the first direction D1. The first through-hole 31a is provided on the left side (+D2 side) relative to the second through-hole 31b. As illustrated in FIG. 2, when viewed from the first direction D1, the first through-hole 31a has a substantially rectangular shape. In the present embodiment, the first holding member 31 is provided with three first through-holes 31a. Each first through-hole 31a is provided at intervals along the third direction D3. When viewed from the first direction D1, the second through-hole 31b has a substantially rectangular shape. In the present embodiment, the first holding member 31 is provided with three second through-holes 31b. Each second through-hole 31b is provided at intervals along the third direction D3. When viewed from the second direction D2, each second through-hole 31b is provided at a position offset from the first through-hole 31a in the third direction D3.

As illustrated in FIG. 3, the plurality of busbars 33 electrically connect the power module 24 and the capacitor module 40. Each busbar 33 is a plate-shaped member. The plurality of busbars 33 include a first busbar 34 and a second busbar 35.

The first busbar 34 includes a first main body portion 34a and a first protruding portion 34b. The first main body portion 34a is held on a surface of the first holding member 31 facing the upper side (+D1 side). As illustrated in FIG. 2, the first main body portion 34a has a plate shape extending in a direction orthogonal to the first direction D1. The front-side (+D3 side) end portion of the first main body portion 34a is positioned further forward than the second connection terminal 26 that is arranged most forward, and is electrically connected to the cathode side of the external power source (not illustrated). As illustrated in FIG. 3, a left-side (+D2 side) portion of the first main body portion 34a is fixed to each second negative terminal 26b by bolts 82. Thus, the first busbar 34 is electrically connected to each second negative terminal 26b. A hole portion 34d is provided in the first main body portion 34a.

The hole portion 34d is a hole penetrating the first main body portion 34a in the first direction D1. As illustrated in FIG. 2, when viewed from the first direction D1, the hole portion 34d has a substantially rectangular shape. In the present embodiment, three hole portions 34d are provided in the first main body portion 34a. Each hole portion 34d is provided at intervals along the third direction D3. When viewed from the first direction D1, each hole portion 34d surrounds a different first through-hole 31a.

As illustrated in FIG. 3, the first protruding portion 34b has a plate shape protruding toward the upper side (+D1 side) from a right-side (-D2 side) end portion of the first main body portion 34a. The plate surface of the first protruding portion 34b faces the second direction D2. As illustrated in FIG. 2, the first busbar 34 includes three first protruding portions 34b. Each first protruding portion 34b is arranged at intervals along the third direction D3.

As illustrated in FIG. 3, the second busbar 35 includes a second main body portion 35a and a second protruding portion 35b. The second main body portion 35a is passed inside the first holding member 31 in the second direction D2. The second main body portion 35a has a plate shape extending in a direction orthogonal to the first direction D1. Although not illustrated, the front-side (+D3 side) end portion of the second main body portion 35a is positioned further forward than the second connection terminal 26 that is arranged most forward, and is electrically connected to the positive electrode side of the external power source (not illustrated). A left-side (+D2 side) portion of the second main body portion 35a is fixed to each second positive terminal 26a by the bolts 82. Thus, the second busbar 35 is electrically connected to each second positive terminal 26a. As described above, the first busbar 34 is electrically connected to each second negative terminal 26b. From these, the busbars 33 are electrically connected to the second connection terminals 26.

The second protruding portion 35b has a plate shape protruding toward the upper side (+D1 side) from the right-side (-D2 side) end portion of the second main body portion 35a. The plate surface of the second protruding portion 35b faces the second direction D2. As illustrated in FIG. 2, the second busbar 35 includes three second protruding portions 35b. Each second protruding portion 35b is arranged at intervals along the third direction D3. As illustrated in FIG. 3, each second protruding portion 35b is passed through a different first through-hole 31a and a different hole portion 34d in the first direction D1. The upper end of each second protruding portion 35b is positioned on the upper side relative to the first main body portion 34a.

In the present embodiment, the capacitor module 40 is arranged on the lower side (-D1 side) relative to the busbar module 30. The capacitor module 40 includes a case portion 41 and a capacitor element 50. The case portion 41 accommodates the capacitor element 50 inside. The case portion 41 includes a first case portion 42, a second case portion 45, and a first flow channel 62.

As illustrated in FIG. 4, the first case portion 42 has a substantially rectangular parallelepiped shape extending in the third direction D3. As illustrated in FIG. 3, two surfaces of the first case portion 42 face the first direction D1, and the other two surfaces of the first case portion 42 face the second direction D2. In the present embodiment, the first case portion 42 is made of metal. A first accommodating portion 42a and a plurality of protruding portions 42c are provided in the first case portion 42.

The first accommodating portion 42a is recessed from a surface of the first case portion 42 facing the upper side, that is, one side of the first direction D1 (+D1 side), toward the lower side, that is, the other side of the first direction D1 (-D1 side). As illustrated in FIG. 4, when viewed from the first direction D1, the first accommodating portion 42a has a substantially rectangular shape having long sides extending in the third direction D3. In the present embodiment, the first case portion 42 is provided with three first accommodating portions 42a. Each first accommodating portion 42a is provided at intervals along the third direction D3.

As illustrated in FIG. 3, each of the plurality of protruding portions 42c protrudes from the first case portion 42 toward the lower side. In the present embodiment, the protruding portions 42c are heat dissipation fins. Although not illustrated, in the present embodiment, each protruding portion 42c is arranged at intervals along each of the second direction D2 and the third direction D3. Each protruding portion 42c may be arranged at intervals along only one of the second direction D2 or the third direction D3. Each protruding portion 42c protrudes into the inside of the first flow channel 62. Note that the first case portion 42 may not be provided with the protruding portions 42c.

As illustrated in FIG. 4, the second case portion 45 has a substantially rectangular parallelepiped shape extending in the third direction D3. As illustrated in FIG. 3, two surfaces of the second case portion 45 face the first direction D1, and the other two surfaces of the second case portion 45 face the second direction D2. The second case portion 45 is provided with a second accommodating portion 45a, a first hole portion 45e, and a second hole portion 45f.

The second accommodating portion 45a is a recess recessed from the surface of the second case portion 45 facing the upper side (+D1 side) toward the lower side (-D1 side). As illustrated in FIG. 4, when viewed from the first direction D1, the second accommodating portion 45a has a substantially rectangular shape having long sides extending in the third direction D3. As illustrated in FIG. 3, the first case portion 42 is accommodated inside the second accommodating portion 45a. The lower end of the second accommodating portion 45a is positioned on the lower side relative to the lower end of the first case portion 42. In the present embodiment, the second case portion 45 is made of resin. In the present embodiment, the second case portion 45 is molded by insert molding using the first case portion 42 as an insert member. Accordingly, the first case portion 42 is fixed to the inner side surface of the second accommodating portion 45a.

As illustrated in FIG. 4, the first hole portion 45e is a hole in a wall portion of the second case portion 45 arranged on the front side (+D3 side), penetrating the wall portion extending in the second direction D2 in the third direction D3. As illustrated in FIG. 3, the first hole portion 45e is provided on the lower side (-D1 side) relative to the first case portion 42. As illustrated in FIG. 4, the first conduit 61 is connected to the first hole portion 45e.

The second hole portion 45f is a hole in a wall portion of the second case portion 45 arranged on the rear side (-D3 side), penetrating the wall portion extending in the second direction D2 in the third direction D3. As illustrated in FIG. 3, the second hole portion 45f is provided on the lower side (-D1 side) relative to the first case portion 42. As illustrated in FIG. 4, the second conduit 63 is connected to the second hole portion 45f.

The first flow channel 62 is a flow channel through which the refrigerant L flows. As illustrated in FIG. 3, the first flow channel 62 is constituted by the outer surface of the first case portion 42 and the inner surface of the second accommodating portion 45a. The first flow channel 62 communicates with the outside of the second case portion 45 through the first hole portion 45e. The first flow channel 62 communicates with the outside of the second case portion 45 through the second hole portion 45f.

The capacitor element 50 serves as a smoothing capacitor that smooths a current supplied from an external power source (not illustrated) to the power module 24. As illustrated in FIG. 4, in the present embodiment, the capacitor module 40 includes a plurality of capacitor elements 50. In the present embodiment, the capacitor module 40 includes three capacitor elements 50. The number of the capacitor elements 50 included in the capacitor module 40 may be two or less, or may be four or more. As illustrated in FIG. 3, each capacitor element 50 includes a capacitor main body portion 51 and a first connection terminal 52.

The capacitor main body portion 51 has a substantially rectangular parallelepiped shape. As illustrated in FIGS. 3 and 4, each capacitor main body portion 51 is accommodated inside a different first accommodating portion 42a. In the present embodiment, each capacitor element 50 is arranged at intervals along the direction in which the first flow channel 62 extends (the third direction D3). Each capacitor main body portion 51 is fixed to the inner surface of the first accommodating portion 42a. Accordingly, the case portion 41 holds the plurality of capacitor elements 50. The outer surface of each capacitor main body portion 51 is constituted by, for example, a material having insulating properties such as resin. Thus, the outer surface of each capacitor main body portion 51 has insulating properties.

As illustrated in FIG. 3, the first connection terminal 52 electrically connects the capacitor main body portion 51 and the busbars 33. The first connection terminal 52 extends from the capacitor main body portion 51 toward the upper side, that is, toward the one side of the first direction D1 (+D1 side). The first connection terminal 52 has conductive properties. In the present embodiment, each capacitor element 50 includes two first connection terminals 52. The two first connection terminals 52 include a first positive terminal 52a and a first negative terminal 52b.

The first positive terminal 52a of each capacitor element 50 is passed through a different first through-hole 31a in the first direction D1. Each of the first positive terminals 52a is fixed to a different second protruding portion 35b of the second busbar 35. Thus, each capacitor element 50 and the second busbar 35 are electrically connected. The first negative terminal 52b is arranged on the right side (-D3 side) relative to the first positive terminal 52a. The first negative terminal 52b of each capacitor element 50 is passed through a different second through-hole 31b in the first direction D1. Each of the first negative terminals 52b is fixed to a different first protruding portion 34b of the second busbar 35. Thus, each capacitor element 50 and the first busbar 34 are electrically connected. As described above, each capacitor element 50 and the second busbar 35 are electrically connected. Thus, the busbars 33 are electrically connected to the first connection terminal 52 of each capacitor element 50. In addition, as described above, the busbars 33 are electrically connected to the second connection terminals 26. Therefore, the busbars 33 electrically connect the first connection terminals 52 and the second connection terminals 26. Note that, in the present embodiment, the first connection terminals 52 and the busbars 33 are fixed by welding. The first connection terminals 52 and the busbars 33 may be fixed by fastening members such as bolts.

The refrigerant flow channel 60 illustrated in FIG. 4 is a flow channel that supplies the refrigerant L to the first flow channel 62 and the second flow channel 65. The refrigerant flow channel 60 is provided with a pump and a cooler (not illustrated). The pump pressurizes and feeds the refrigerant L. The cooler cools the refrigerant L. In the present embodiment, the refrigerant L is a liquid, for example, water, oil, and the like. The refrigerant flow channel 60 includes the first conduit 61, the first flow channel 62, the second conduit 63, the third conduit 64, the second flow channel 65, and the fourth conduit 66. In the present embodiment, each of the first conduit 61, the second conduit 63, the third conduit 64, and the fourth conduit 66 is a pipe. In the present embodiment, the refrigerant L flows in the order of the first conduit 61, the first flow channel 62, the second conduit 63, the third conduit 64, the second flow channel 65, and the fourth conduit 66. The refrigerant L may flow in the order of the fourth conduit 66, the second flow channel 65, the third conduit 64, the second conduit 63, the first flow channel 62, and the first conduit 61.

The first conduit 61 is fixed to the first hole portion 45e. Thus, the first conduit 61 is connected to the first flow channel 62 through the first hole portion 45e. The first flow channel 62 connects the first conduit 61 and the second conduit 63. In the first flow channel 62, the refrigerant L flows from the front side (+D3 side) toward the rear side (-D3 side). As illustrated in FIG. 3, each protruding portion 42c provided in the first case portion 42 protrudes into the inside of the first flow channel 62. Each protruding portion 42c contacts the refrigerant L flowing through the first flow channel 62. Thus, the contact area between the refrigerant L flowing through the first flow channel 62 and the first case portion 42 can be increased.

As illustrated in FIG. 4, the second conduit 63 connects the first flow channel 62 and the third conduit 64. One end of the second conduit 63 is fixed to the second hole portion 45f. Thus, the second conduit 63 is connected to the first flow channel 62 through the second hole portion 45f. The other end of the second conduit 63 is connected to one end of the third conduit 64. The third conduit 64 connects the second conduit 63 and the second flow channel 65. The other end of the third conduit 64 is fixed to the third hole portion 22c. Thus, the third conduit 64 is connected to the second flow channel 65 through the third hole portion 22c.

The second flow channel 65 connects the third conduit 64 and the fourth conduit 66. In the second flow channel 65, the refrigerant L flows from the rear side (-D3 side) toward the front side (+D3 side). As described above, each of the plurality of fin portions 23c included in the heat sink 23 protrudes into the inside of the second flow channel 65. Each fin portion 23c contacts the refrigerant L flowing through the second flow channel 65. Accordingly, the contact area between the refrigerant L flowing through the second flow channel 65 and the heat sink 23 can be increased. The fourth conduit 66 is fixed to the fourth hole portion 22d. Thus, the fourth conduit 66 is connected to the second flow channel 65. The refrigerant L flowing from the second flow channel 65 into the fourth conduit 66 is discharged to the outside of the power conversion device 10.

According to the present embodiment, the power conversion device 10 includes the capacitor module 40 including the capacitor element 50 and the case portion 41 accommodating the capacitor element 50, the power module 24 including the power semiconductor elements 24c that perform power conversion, the control board 25 that drives the power module 24, and the busbar module 30 including the busbars 33. The capacitor element 50 includes the capacitor main body portion 51 and the first connection terminals 52 extending to the upper side from the capacitor main body portion 51, that is, toward the one side of the first direction D1 (+D1 side), the power module 24 includes the second connection terminals 26, and the busbars 33 electrically connect the first connection terminals 52 and the second connection terminals 26. The case portion 41 includes the first accommodating portion 42a recessed from the upper side toward the lower side, that is, toward the other side of the first direction D1 (-D1 side), and accommodating the capacitor main body portion 51, and the first flow channel 62 through which the refrigerant L flows. Therefore, since the case portion 41 accommodating the capacitor main body portion 51 includes the first flow channel 62, the thermal resistance between the capacitor element 50 and the first flow channel 62 can be reduced, as compared with a case in which the first flow channel 62 is provided in a member different from the case portion 41. Thus, the amount of heat transferred from the capacitor element 50 to the refrigerant L flowing through the first flow channel 62 can be increased. Therefore, an excessive increase in the temperature of the capacitor element 50 can be suppressed. Accordingly, deterioration of the capacitor element 50 can be suppressed.

In addition, in the present embodiment, since the first flow channel 62 is provided in the case portion 41, compared with a case in which the first flow channel 62 is provided in the housing 11, simplification of the shape and the configuration of the housing 11 can be achieved. Thus, an increase in the manufacturing cost of the housing 11 can be suppressed. Therefore, an increase in the manufacturing cost of the power conversion device 10 can be suppressed.

For example, in a case in which the capacitor elements 50 and the busbars 33 are electrically connected and then integrated by insert molding, the number of components to be inserted increases, and therefore the number of steps required for manufacturing the integrated unit tend to increase. In contrast, in the present embodiment, after the capacitor module 40 and the busbar module 30 are manufactured separately, the capacitor elements 50 and the busbars 33 can be electrically connected. Therefore, the number of components of insert members in each of the modules 30 and 40 can be easily reduced. Therefore, an increase in the number of manufacturing steps for each of the modules 30 and 40 can be easily suppressed, and an increase in the number of manufacturing steps for the power conversion device 10 can also be suppressed.

In addition, in the present embodiment, the capacitor module 40, the busbar module 30, and the power module 24 can be manufactured in parallel in the manufacturing process of the power conversion device 10, and therefore an increase in the number of manufacturing steps for the power conversion device 10 can be suppressed more suitably and easily.

According to the present embodiment, the case portion 41 includes a first case portion 42 in which the first accommodating portion 42a is provided, and a second case portion 45 in which the second accommodating portion 45a that accommodates the first case portion 42 is provided, and the first flow channel 62 is constituted by the outer surface of the first case portion 42 and the inner surface of the second case portion 45. Therefore, the refrigerant L flowing through the first flow channel 62 can be brought into direct contact with the first case portion 42 that accommodates the capacitor main body portion 51. Thus, the amount of heat transferred from the capacitor element 50 to the refrigerant L flowing through the first flow channel 62 can be more suitably increased. Therefore, an excessive increase in the temperature of the capacitor element 50 can be more suitably suppressed. Accordingly, deterioration of the capacitor element 50 can be more suitably suppressed.

According to the present embodiment, the first case portion 42 is made of metal. Therefore, the thermal conductivity of the first case portion 42 can be increased as compared with the case in which the first case portion 42 is made of resin. Thus, the amount of heat transferred from the capacitor element 50 to the refrigerant L flowing through the first flow channel 62 can be more suitably increased. Therefore, an excessive increase in the temperature of the capacitor element 50 can be more suitably suppressed.

According to the present embodiment, the first case portion 42 is provided with the plurality of protruding portions 42c that protrude into the inside of the first flow channel 62. Therefore, as described above, the contact area between the refrigerant L flowing through the first flow channel 62 and the first case portion 42 can be increased. Thus, the amount of heat transferred from the capacitor element 50 to the refrigerant L flowing through the first flow channel 62 can be more suitably increased. Therefore, an excessive increase in the temperature of the capacitor element 50 can be more suitably suppressed.

According to the present embodiment, the second case portion 45 is made of resin and is molded by insert molding using the first case portion 42 as an insert member. Therefore, since the case portion 41 can be manufactured easily, an increase in the manufacturing steps and the manufacturing cost of the capacitor module 40 can be suppressed.

The busbar module 30 includes the plurality of busbars 33 and the first holding member 31 made of resin that holds the plurality of busbars 33, and the first holding member 31 is molded by insert molding using the plurality of busbars 33 as insert members. Therefore, since the busbar module 30 can be manufactured easily, an increase in the manufacturing steps and the manufacturing cost of the busbar module 30 can be suppressed.

The plurality of busbars 33 include the first busbar 34 and the second busbar 35 through which currents having substantially equal magnitudes flow in mutually opposite directions. In the present embodiment, by arranging a part of the first holding member 31 having insulating properties between the first busbar 34 and the second busbar 35, the first busbar 34 and the second busbar 35 can be arranged close to each other easily. Therefore, mutual inductance generated by the current flowing through the first busbar 34 and the current flowing through the second busbar 35 acts so as to cancel self-inductance, and parasitic inductance generated in each busbar 33 can be reduced. As a result, an increase in surge noise generated by the switching operation of the power semiconductor elements 24c of the power module 24 can be suppressed. Therefore, an increase in the size of a noise filter provided to remove noise generated in the power module 24 can be suppressed. As a result, an increase in the size of the power conversion device 10 can be suppressed, and an increase in the manufacturing cost of the power conversion device 10 can be suppressed.

According to the present embodiment, the first connection terminals 52 and the busbars 33 are fixed by welding. Thus, compared with a case in which the first connection terminals 52 and the busbars 33 are fixed by fastening members such as bolts, a space for arranging fastening members becomes unnecessary. Therefore, an increase in the size of each of the capacitor module 40 and the busbar module 30 can easily be suppressed. As a result, an increase in the size of the power conversion device 10 can be more suitably suppressed.

In addition, in the present embodiment, compared with a case in which the first connection terminals 52 and the busbars 33 are fixed by fastening members such as bolts, a step of measuring a tightening torque of the fastening members in a manufacturing process of the power conversion device 10 becomes unnecessary. Therefore, an increase in the manufacturing steps of the power conversion device 10 can be more suitably suppressed.

In addition, in a case in which the first connection terminals 52 and the busbars 33 are fixed by fastening members, when a tightening torque of the fastening members is too small, contact resistance between the first connection terminals 52 and the busbars 33 increases. As a result, an amount of heat generated at the connection portion between the first connection terminals 52 and the busbars 33 increases. In contrast, in the present embodiment, as described above, since the first connection terminals 52 and the busbars 33 are fixed by welding, an increase in contact resistance between the first connection terminals 52 and the busbars 33 can easily be suppressed. Therefore, an increase in the amount of heat generated at the connection portion between the first connection terminals 52 and the busbars 33 can be suppressed.

According to the present embodiment, the power conversion device 10 includes the holding portion 21 that holds the power module 24, and the holding portion 21 is provided with the second flow channel 65 through which the refrigerant L flows. Therefore, compared with a case in which the second flow channel 65 is provided in a member different from the holding portion 21, thermal resistance between the power module 24 and the second flow channel 65 can be reduced. As a result, the amount of heat transferred from the power module 24 to the refrigerant L flowing through the second flow channel 65 can be increased. Therefore, an excessive increase in the temperature of the power module 24 can be suppressed.

In addition, in the present embodiment, since the second flow channel 65 is provided in the holding portion 21, compared with a case in which the second flow channel 65 is provided in the housing 11, simplification of the shape and the configuration of the housing 11 can be more suitably achieved. Thus, an increase in the manufacturing cost of the housing 11 can be more suitably suppressed. Therefore, an increase in the manufacturing cost of the power conversion device 10 can be more suitably suppressed.

### Second Embodiment

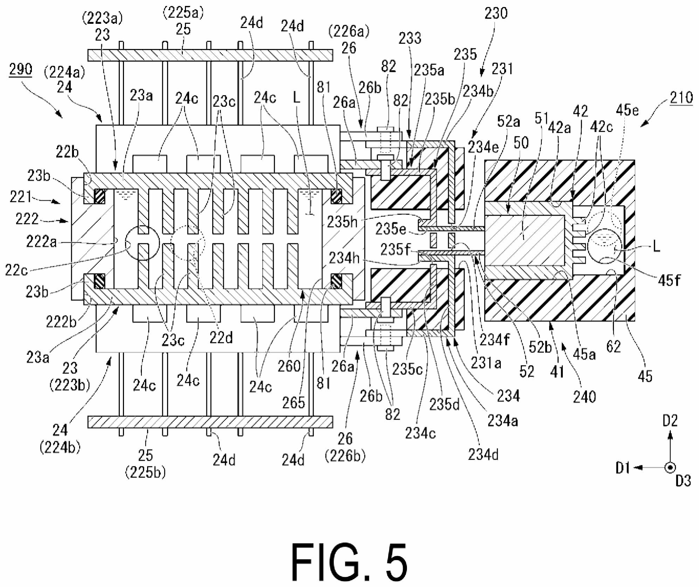

In the following description, a first direction D1 is indicated in FIG. 5. In the present embodiment, the first direction D1 is the left-right direction of a power conversion device 210. In the following description, a side toward which an arrow of the first direction D1 points (+D1 side) is referred to as "one side of the first direction D1" or a "left side". The side opposite to the side toward which an arrow of the first direction D1 points (-D1 side) is referred to as "the other side of the first direction D1" or a "right side".

In the following description, a second direction D2 is indicated in FIG. 5. In the present embodiment, the second direction D2 is the up-down direction of the power conversion device 210. The second direction D2 intersects with the first direction D1. In the present embodiment, the second direction D2 is orthogonal to the first direction D1. In the following description, a side toward which an arrow of the second direction D2 points (+D2 side) is referred to as an "upper side". The side opposite to the side toward which the arrow of the second direction D2 points (-D2 side) is referred to as a "lower side".

In the following description, a third direction D3 is appropriately indicated in each drawing. The third direction D3 is a front-rear direction of the power conversion device 210, as in the first embodiment described above. Note that the upper side, the lower side, the left side, the right side, the front side, and the rear side are merely names for describing the relative positional relationships of respective portions, and the actual arrangement relationships and the like may be the arrangement relationships and the like other than the arrangement relationships and the like indicated by these names.

FIG. 5 is a cross-sectional view illustrating a part of the power conversion device 210 in a motor module 290 of the present embodiment. The power conversion device 210 includes a housing 11 (not illustrated), a holding portion 221, a pair of power modules 24, a pair of control boards 25, a busbar module 230, a capacitor module 240, and a refrigerant flow channel 260. In the following description, components similar to those of the first embodiment described above are denoted by the same reference signs, and description thereof will be omitted.

The holding portion 221 holds the power module 24. In the second direction D2, the holding portion 221 is arranged between the pair of power modules 24. The power modules 24 are fixed to the upper end and the lower end of the holding portion 221. The holding portion 221 includes a holding case 222 and a pair of heat sinks 23.

Although not illustrated, the holding case 222 has a substantially rectangular parallelepiped shape extending in the third direction D3. Two surfaces of the holding case 222 face the first direction D1, and the other two surfaces of the holding case 222 face the second direction D2. The holding case 222 is provided with a first recess portion 222a, second recess portions 22b and 222b, a third hole portion 22c, and a fourth hole portion 22d.

The first recess portion 222a is recessed toward the lower side from the surface of the holding case 222 facing the upper side (+D2 side). Although not illustrated, when viewed from the first direction D1, the first recess portion 222a has a substantially rectangular shape. In the present embodiment, the first recess portion 222a opens toward the lower side (-D2 side). The second recess portion 22b is recessed toward the lower side from the surface of the holding case 222 facing the upper side. The second recess portion 222b is recessed toward the upper side from the surface of the holding case 222 facing the lower side. Although not illustrated, when viewed from the first direction D1, the second recess portions 22b and 222b have a substantially rectangular annular shape having long sides extending in the third direction D3. The second recess portions 22b and 222b surround the first recess portion 222a from outer sides in each of the second direction D2 and the third direction D3.

Each of the pair of heat sinks 23 transfers heat generated in the power module 24 to the refrigerant L flowing through a second flow channel 265. One heat sink 223a is arranged on the upper side (+D2 side) relative to the holding case 222. The other heat sink 223b is arranged on the lower side (-D2 side) relative to the holding case 222. With a surface orthogonal to the second direction D2 and passing between the pair of heat sinks 223a and 223b as the symmetry plane, the shapes of the heat sinks 223a and 223b have plane symmetry with respect to each other.

The fixing portion 23b of the one heat sink 223a is arranged inside the second recess portion 22b and is fixed to the inner surface of the second recess portion 22b. The fixing portion 23b of the other heat sink 223b is arranged inside the second recess portion 222b and is fixed to the inner surface of the second recess portion 222b. Thus, the pair of heat sinks 23 are fixed to the holding case 222.

Each fin portion 23c of the one heat sink 223a protrudes towards the lower side (-D2 side) from a main body portion 23a. Each fin portion 23c of the other heat sink 223b protrudes toward the upper side (+D2 side) from the main body portion 23a. Each fin portion 23c is arranged inside the first recess portion 222a.

The holding portion 221 is provided with the second flow channel 265 through which the refrigerant L flows. In the present embodiment, the second flow channel 265 is constituted by the inner surface of the first recess portion 222a, the surface of the main body portion 23a of the one heat sink 223a facing the lower side, the surface of the main body portion 23a of the other heat sink 223b facing the upper side, and the outer surface of each fin portion 23c. Each fin portion 23c is in contact with the refrigerant L flowing through the second flow channel 265. Other configurations and the like of the holding portion 221 of the present embodiment are similar to other configurations and the like of the holding portion 21 of the first embodiment described above.

Each of the pair of power modules 24 generates a current having a predetermined waveform from a current supplied by an external power source (not illustrated), and supplies the current to a motor 91. Each power module 24 includes power semiconductor elements 24c and second connection terminals 26. Configurations and the like of each of the power semiconductor element 24c and the second connection terminal 26 of the present embodiment are similar to configurations and the like of each of the power semiconductor element 24c and the second connection terminal 26 of the first embodiment described above.

The second connection terminal 26 electrically connects the power semiconductor elements 24c arranged inside the power module 24 and the busbar module 30. Although not illustrated, one power module 224a includes six second connection terminals 226a. The six second connection terminals 226a include three second positive terminals 26a and three second negative terminals 26b. The other power module 224b includes six second connection terminals 226b. The six second connection terminals 226b include three second positive terminals 26a and three second negative terminals 26b. Each second positive terminal 26a is electrically connected to a different pair of power semiconductor elements 24c. Each second negative terminal 26b is electrically connected to a different pair of power semiconductor elements 24c. Thus, a current is supplied from the busbar module 230 to each pair of power semiconductor elements 24c via the second connection terminal 26. Other configurations and the like of the power module 24 are similar to configurations and the like of the power module 24 of the first embodiment described above.

One control board 225a for driving the one power module 224a is arranged on the upper side (+D2 side) relative to the one heat sink 223a. The other control board 225b for driving the other power module 224b is arranged on the lower side (-D2 side) relative to the other heat sink 223b. A connection pin 24d electrically connects the one power module 224a and the one control board 225a. Accordingly, each power semiconductor element 24c included in the one power module 224a and the one control board 225a are electrically connected. In addition, the connection pin 24d electrically connects the other power module 224b and the other control board 225b. Thus, each power semiconductor element 24c included in the other power module 224b and the other control board 225b are electrically connected. Each control board 25 controls power conversion of each power module 24 by providing control pulses to each power semiconductor element 24c.

As illustrated in FIG. 3, in the present embodiment, the busbar module 230 is arranged on the right side (-D1 side) relative to the power module 24 and on the left side (+D1 side) relative to the capacitor module 40. The busbar module 230 includes a first holding member 231 and a plurality of busbars 233.

Although not illustrated, the first holding member 231 has a substantially rectangular parallelepiped shape extending in the third direction D3. Two surfaces of the first holding member 231 face the first direction D1, and the other two surfaces of the first holding member 231 face the second direction D2. In the present embodiment, the first holding member 231 is made of resin and has insulating properties. In the present embodiment, the first holding member 231 is molded by insert molding using the plurality of busbars 233 as insert members. Accordingly, the first holding member 231 holds each busbar 233. The first holding member 231 is provided with a first through-hole 231a.

The first through-hole 231a is a hole that penetrates the first holding member 231 in the first direction D1. In the present embodiment, the first holding member 231 is provided with three first through-holes 231a. Although not illustrated, each first through-hole 231a is provided at intervals along the third direction D3.

The plurality of busbars 233 electrically connect the power module 24 and the capacitor module 240. Each busbar 233 is a plate-shaped member. The plurality of busbars 233 include a first busbar 234 and a second busbar 235.

The first busbar 234 includes a first main body portion 234a and a first protruding portion 234h. The first main body portion 234a is held by the first holding member 231. The first main body portion 234a is a plate-shaped member. Although not illustrated, the front-side (+D3 side) end portion of the first main body portion 234a is positioned further forward than the second connection terminal 26 that is arranged at the most forward. The rear-side (-D3 side) end portion of the first main body portion 234a is positioned further rearward than the second connection terminal 26 that is arranged at the most rearward. The first main body portion 234a includes a first portion 234b, a second portion 234c, and a third portion 234d.

Each of the first portion 234b and the second portion 234c has a plate shape protruding in the first direction D1. The plate surface of each of the first portion 234b and the second portion 234c faces the second direction D2. A left-side (+D1 side) portion of the first portion 234b is fixed to each second negative terminal 26b of the one power module 224a by bolts 82. A left-side (+D1 side) portion of the second portion 234c is fixed to each second negative terminal 26b of the other power module 224b by the bolts 82. Accordingly, the first busbar 234 is electrically connected to the pair of power modules 24.

The third portion 234d has a plate shape extending in the second direction D2. The plate surface of the third portion 234d faces the first direction D1. The upper end of the third portion 234d is connected to the right-side (-D1 side) end portion of the first portion 234b. The lower end of the third portion 234d is connected to the right-side end portion of the second portion 234c. The third portion 234d is provided with a first hole 234e and a second hole 234f.

Each of the first hole 234e and the second hole 234f is a hole that penetrates the third portion 234d in the first direction D1. When viewed from the third direction D3, the first hole 234e is provided on the upper side (+D2 side) relative to the second hole 234f. In the present embodiment, three first holes 234e are provided. Each first hole 234e is arranged at intervals in the third direction D3. In the present embodiment, three second holes 234f are provided. Each second hole 234f is arranged at intervals in the third direction D3.

The first protruding portion 234h has a plate shape protruding from the third portion 234d to the left side (+D1 side). The plate surface of the first protruding portion 234h faces the second direction D2. Although not illustrated, the first busbar 234 includes three first protruding portions 234h. Each first protruding portion 234h is arranged at intervals along the third direction D3. Other configurations and the like of the first busbar 234 are similar to other configurations and the like of the first busbar 34 of the first embodiment described above.

The second busbar 235 includes a second main body portion 235a and a second protruding portion 235h. The second main body portion 235a is held by the first holding member 231. The second main body portion 235a is a plate-shaped member. Although not illustrated, the front-side (+D3 side) end portion of the second main body portion 235a is positioned further forward than the second connection terminal 26 that is arranged at the most forward. The rear-side (-D3 side) end portion of the second main body portion 235a is positioned further rearward than the second connection terminal 26 that is arranged at the most rearward. The second main body portion 235a includes a fourth portion 235b, a fifth portion 235c, and a sixth portion 235d.

Each of the fourth portion 235b and the fifth portion 235c has a plate shape protruding in the first direction D1. The plate surface of each of the fourth portion 235b and the fifth portion 235c faces the second direction D2. A left-side (+D1 side) portion of the fourth portion 235b is fixed to each second positive terminal 26a of the one power module 224a by the bolts 82. A left-side (+D1 side) portion of the fifth portion 235c is fixed to each second positive terminal 26a of the other power module 224b by the bolts 82. Thus, the second busbar 235 is electrically connected to the pair of power modules 24.

The sixth portion 235d has a plate shape extending in the second direction D2. The plate surface of the sixth portion 235d faces the first direction D1. The upper end of the sixth portion 235d is connected to the right-side (-D1 side) end portion of the fourth portion 235b. The lower end of the sixth portion 235d is connected to the right-side end portion of the fifth portion 235c. The sixth portion 235d is provided with a third hole 235e and a fourth hole 235f.

Each of the third hole 235e and the fourth hole 235f is a hole penetrating the sixth portion 235d in the first direction D1. When viewed from the third direction D3, the third hole 235e is provided on the upper side (+D2 side) relative to the fourth hole 235f. In the present embodiment, three third holes 235e are provided. Each third hole 235e is provided at intervals in the third direction D3. In the present embodiment, three fourth holes 235f are provided. Each fourth hole 235f is provided at intervals in the third direction D3. When viewed from the first direction D1, a part of the third hole 235e overlaps with a part of the first hole 234e. When viewed from the first direction D1, a part of the fourth hole 235f overlaps with a part of the second hole 234f.

The second protruding portion 235h has a plate shape protruding from the sixth portion 235d to the left side (+D1 side). The plate surface of the second protruding portion 235h faces the second direction D2. Although not illustrated, the second busbar 235 includes three second protruding portions 235h. Each second protruding portion 235h is arranged at intervals along the third direction D3. Other configurations and the like of the second busbar 235 of the present embodiment are similar to other configurations and the like of the second busbar 35 of the first embodiment described above.

In the present embodiment, the capacitor module 240 is arranged on the right side (-D1 side) relative to the busbar module 230. The capacitor module 240 includes a case portion 41 and capacitor elements 50. When viewed from the front side (+D3 side), the capacitor module 240 of the present embodiment is arranged in a state in which the capacitor module 40 of the first embodiment is rotated counterclockwise by 90 degrees about an axis extending in the third direction D3. Accordingly, a first accommodating portion 42a is recessed from the surface of a first case portion 42 facing the left side, that is, one side of the first direction D1 (+D1 side), toward the right side, that is, the other side of the first direction D1 (-D1 side). Each protruding portion 42c protrudes into the inside of the first flow channel 62. The second accommodating portion 45a is recessed from the surface of the second case portion 45 facing the left side toward the right side. The first flow channel 62 is constituted by the outer surface of the first case portion 42 and the inner surface of a second accommodating portion 45a. Other configurations and the like of the case portion 41 are similar to other configurations and the like of the case portion 41 of the first embodiment described above.

Each capacitor main body portion 51 is accommodated inside a different first accommodating portion 42a. The first connection terminal 52 extends to the left side from the capacitor main body portion 51, that is, toward the one side (+D1 side) of the first direction D1. The two first connection terminals 52 include a first positive terminal 52a and a first negative terminal 52b.

The first positive terminal 52a of each capacitor element 50 is passed through a different first through-hole 231a in the first direction D1. Each first positive terminal 52a is passed through the first hole 234e of the first busbar 234 and the third hole 235e of the second busbar 235 in the first direction D1, and is fixed to a different second protruding portion 235h of the second busbar 235. Thus, each capacitor element 50 and the second busbar 235 are electrically connected. The first negative terminal 52b of each capacitor element 50 is passed through a different first through-hole 231a in the first direction D1. Each first positive terminal 52a is passed through the second hole 234f of the first busbar 234 and the fourth hole 235f of the second busbar 235 in the first direction D1, and is fixed to a different first protruding portion 234h of the first busbar 234. Thus, each capacitor element 50 and the first busbar 234 are electrically connected. Therefore, the busbars 233 electrically connect the first connection terminals 52 and the second connection terminals 26. Note that, in the present embodiment, the first connection terminal 52 and the busbars 233 are fixed by welding. Other configurations and the like of the capacitor module 240 of the present embodiment are similar to other configurations and the like of the capacitor module 40 of the first embodiment described above.

The refrigerant flow channel 260 of the present embodiment is a flow channel that supplies the refrigerant L to the first flow channel 62 and the second flow channel 265. The refrigerant flow channel 260 includes a first conduit 61 (see FIG. 4), a first flow channel 62, a second conduit 63 (see FIG. 4), a third conduit 64 (see FIG. 4), the second flow channel 265, and a fourth conduit 66 (see FIG. 4).

The second flow channel 265 connects the third conduit 64 and the fourth conduit 66 illustrated in FIG. 4. Although not illustrated, in the second flow channel 265, the refrigerant L flows from the rear side (-D3 side) toward the front side (+D3 side). As described above, each of the plurality of fin portions 23c included in the pair of heat sinks 23 is in contact with the refrigerant L flowing through the second flow channel 265. Thus, the contact area between the refrigerant L flowing through the second flow channel 265 and the pair of heat sinks 23 can be increased. Other configurations and the like of the refrigerant flow channel 260 of the present embodiment are similar to the configurations and the like of the refrigerant flow channel 60 of the first embodiment described above.

According to the present embodiment, the capacitor element 50 includes the capacitor main body portion 51 and the first connection terminal 52 extending from the capacitor main body portion 51 to the left side, that is, toward the one side of the first direction (+D1 side), and the case portion 41 includes the first accommodating portion 42a recessed from the left side toward the right side, that is, toward the other side of the first direction D1 (-D1 side), and accommodating the capacitor main body portion 51, and the first flow channel 62 through which the refrigerant L flows. Therefore, compared with a case in which the first flow channel 62 is provided in a member different from the case portion 41, thermal resistance between the capacitor element 50 and the first flow channel 62 can be reduced. Thus, the amount of heat transferred from the capacitor element 50 to the refrigerant L flowing through the first flow channel 62 can be increased. Therefore, an excessive increase in the temperature of the capacitor element 50 can be suppressed. Accordingly, deterioration of the capacitor element 50 can be suppressed.

In addition, in the present embodiment, compared with a configuration in which the first flow channel 62 is provided in the housing 11, simplification of the shape of the housing 11 can be achieved. Thus, an increase in the manufacturing cost of the housing 11 can be suppressed.

According to the present embodiment, the power conversion device 210 includes the holding portion 221 that holds the power module 24, and the holding portion 221 is provided with the second flow channel 265 through which the refrigerant L flows. Therefore, the thermal resistance between the power module 24 and the second flow channel 265 can be reduced as compared with a case in which the second flow channel 265 is provided in a member different from the holding portion 221. As a result, the amount of heat transferred from the power module 24 to the refrigerant L flowing through the second flow channel 265 can be increased. Therefore, an excessive increase in the temperature of the power module 24 can be suppressed.

In addition, in the present embodiment, since the second flow channel 265 is provided in the holding portion 221, compared with a case in which the second flow channel 265 is provided in the housing 11, simplification of the shape and the configuration of the housing 11 can be more suitably achieved. Thus, an increase in the manufacturing cost of the housing 11 can be more suitably suppressed.

The present invention is not limited to the embodiments described above, and other configurations and other methods can be adopted within the scope of the technical idea of the present invention.

For example, the power module or the power semiconductor element may be in direct contact with the refrigerant without the heat sink as long as the insulating properties can be ensured. In this case, the amount of heat transferred from the power semiconductor element to the refrigerant can be further increased.

The application of the power conversion device of the present embodiment is not limited to generation of a current to be supplied to a motor that drives a vehicle, and a current to be supplied to a drive device such as a motor mounted on an electrical appliance or the like may be generated. Further, the power conversion device may be an inverter that generates an alternating current having a predetermined waveform from a direct current supplied from an external power source, or may be a converter that generates a direct current from an alternating current supplied from an external power source.

While the embodiments of the present invention have been described above, the configurations in the embodiments, combinations thereof, and the like are an example, and additions, omissions, substitutions, and other modifications of the configurations can be made without departing from the spirit of the present invention. Furthermore, the present invention is not limited to the embodiments.

Note that the present technology can have configurations such as the following.
(1) A power conversion device including a capacitor module including a capacitor element and a case portion accommodating the capacitor element, a power module including a power semiconductor element configured to perform power conversion, a control board configured to drive the power module, and a busbar module including a busbar, in which the capacitor element includes a capacitor main body portion and a first connection terminal extending from the capacitor main body portion toward one side in a first direction, the power module includes a second connection terminal, the busbar electrically connects the first connection terminal and the second connection terminal, and the case portion includes a first accommodating portion recessed from the one side of the first direction toward the other side of the first direction and accommodating the capacitor main body portion, and a first flow channel through which a refrigerant flows.
(2) The power conversion device according to (1), in which the case portion includes a first case portion provided with the first accommodating portion and a second case portion provided with a second accommodating portion accommodating the first case portion, and the first flow channel is constituted by an outer surface of the first case portion and an inner surface of the second case portion.
(3) The power conversion device according to (2), in which the first case portion is made of metal.
(4) The power conversion device according to (2) or (3), in which the first case portion includes a plurality of protruding portions protruding into an inside of the first flow channel.
(5) The power conversion device according to any one of (2) to (4), in which the second case portion is made of resin and molded by insert molding using the first case portion as an insert member.
(6) The power conversion device according to any one of (1) to (5), in which the busbar module includes a plurality of the busbars and a first holding member made of resin and holding the plurality of busbars, and the first holding member is molded by insert molding using the plurality of busbars as insert members.
(7) The power conversion device according to any one of (1) to (6), in which the first connection terminal and the busbar are fixed by welding.
(8) The power conversion device according to any one of (1) to (7), further including a holding portion configured to hold the power module, in which the holding portion includes a second flow channel through which the refrigerant flows.
(9) A motor module including the power conversion device according to any one of (1) to (8), and a motor configured to be driven by a current supplied from the power conversion device.

### Reference Signs List

10, 210: Power conversion device, 21, 221: Holding portion, 22: Holding case, 23: Heat sink, 24: Power module, 25: Control board, 24c: Power semiconductor element, 26: Second connection terminal, 30, 230: Busbar module, 31, 231: First holding member, 33, 233: Busbar, 40, 240: Capacitor module, 41: Case portion, 42: First case portion, 42a: First accommodating portion, 42c: Protruding portion, 45: Second case portion, 45a: Second accommodating portion, 50: Capacitor element, 51: Capacitor main body portion, 52: First connection terminal, 62: First flow channel, 65, 265: Second flow channel, 90: Motor module, 91: Motor, D1: First direction, L: Refrigerant

## Claims

1. A power conversion device comprising:
a capacitor module including a capacitor element and a case portion accommodating the capacitor element;
a power module including a power semiconductor element configured to perform power conversion;
a control board configured to drive the power module; and
a busbar module including a busbar,
wherein the capacitor element includes a capacitor main body portion and a first connection terminal extending from the capacitor main body portion toward one side in a first direction,
the power module includes a second connection terminal,
the busbar electrically connects the first connection terminal and the second connection terminal, and
the case portion includes a first accommodating portion recessed from the one side of the first direction toward the other side of the first direction and accommodating the capacitor main body portion and a first flow channel through which a refrigerant flows.

2. The power conversion device according to claim 1,
wherein the case portion includes a first case portion provided with the first accommodating portion and a second case portion provided with a second accommodating portion accommodating the first case portion, and
the first flow channel is constituted by an outer surface of the first case portion and an inner surface of the second case portion.

3. The power conversion device according to claim 2,
wherein the first case portion is made of metal.

4. The power conversion device according to claim 2,
wherein the first case portion includes a plurality of protruding portions protruding into an inside of the first flow channel.

5. The power conversion device according to claim 2,
wherein the second case portion is made of resin and molded by insert molding using the first case portion as an insert member.

6. The power conversion device according to claim 1,
wherein the busbar module includes a plurality of the busbars and a first holding member made of resin and holding the plurality of busbars, and
the first holding member is molded by insert molding using the plurality of busbars as insert members.

7. The power conversion device according to claim 1,
wherein the first connection terminal and the busbar are fixed by welding.

8. The power conversion device according to claim 1, further comprising:
a holding portion configured to hold the power module,
wherein the holding portion includes a second flow channel through which the refrigerant flows.

9. A motor module comprising:
the power conversion device according to any one of claims 1 to 8; and
a motor configured to be driven by a current supplied from the power conversion device.
